# FASCICULE DE BREVET EUROPEEN

(11) **EP 0 746 109 B1**
(45) Date de publication et mention de la délivrance du brevet: **15.11.2000**
(21) Numéro de dépôt: 96410059.8
(22) Date de dépôt: 28.05.1996
(51) Int. Cl.: H03K 23/66, H03K 21/40

(54) **Diviseur de fréquence programmable rapide**
Schneller programmierbarer Frequenzteiler
Fast programmable frequency divider

(30) Priorité: 31.05.1995 FR 9506667
(43) Date de publication de la demande: 04.12.1996
(73) Titulaire: STMicroelectronics S.A., 94250 Gentilly (FR)
(72) Inventeur: Colavin, Osvaldo, 38340 Voreppe (FR)
(74) Mandataire: de Beaumont, Michel

(56) Documents cités:
- WO-A-90/05413
- DE-A- 3 200 752
- PATENT ABSTRACTS OF JAPAN vol. 5, no. 181 (E-83) [853] , 20 Novembre 1981 & JP-A-56 107636 (TATEISHI DENKI K.K. ), 28 Août 1981,

## Description

La présente invention concerne un diviseur programmable rapide destiné à diviser par un taux variable une fréquence élevée, par exemple d'un oscillateur commandé d'une boucle à verrouillage de phase.

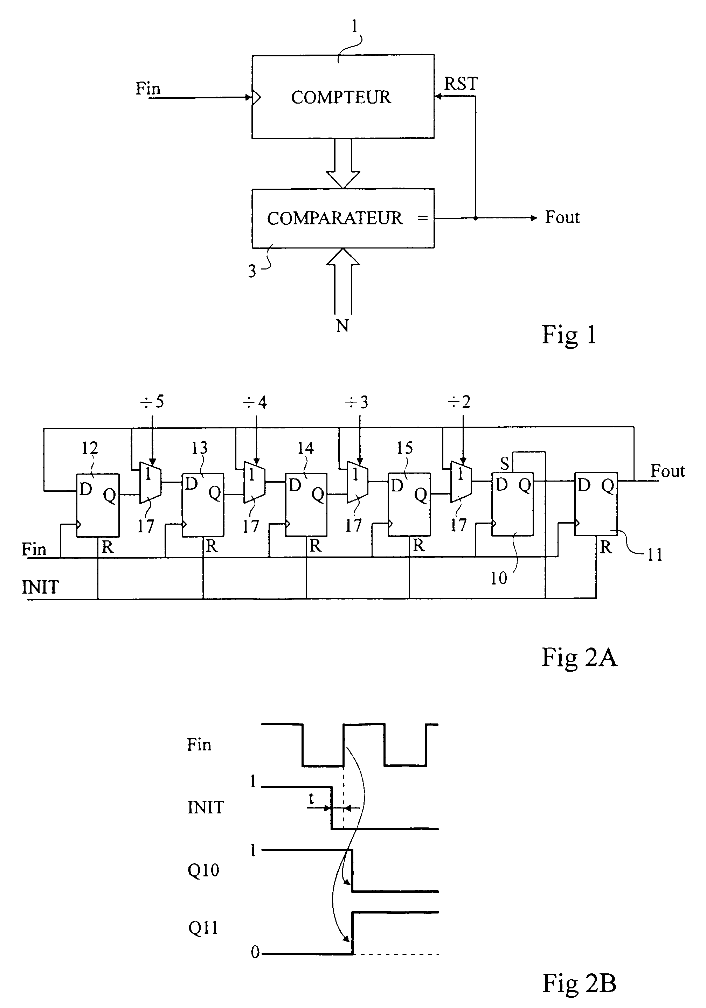

La figure 1 représente un diviseur programmable classique. Ce diviseur comprend un compteur 1 cadencé à la fréquence à diviser Fin. Le contenu du compteur 1 est comparé à un nombre N par un comparateur 3. En cas d'égalité, le comparateur 3 fournit un signal de remise à zéro RST au compteur 1. La fréquence divisée à obtenir Fout est prélevée sur le signal de remise à zéro RST. En effet, le comparateur 3 délivre normalement une impulsion à chaque fois que le compteur 1 a compté N périodes du signal Fin.

Pour que le compteur 1 soit le plus rapide possible, il est de type asynchrone, c'est-à-dire que ses bits ne varient pas en phase avec la fréquence Fin.

A l'aide d'un diviseur programmable du type de la figure 1, on peut atteindre une vitesse de fonctionnement proche de la fréquence maximale admise par la technologie dans laquelle le diviseur est réalisé. Toutefois, cette performance s'obtient au prix d'un effort considérable de dimensionnement de chacun des transistors du diviseur, ce dimensionnement ne pouvant pas être transposé d'une technologie à une autre. Ainsi, notamment, à chaque apparition d'une nouvelle technologie, on doit faire de considérables efforts de développement pour faire fonctionner un diviseur du type de la figure 1 à la fréquence maximale possible. Le document DE 3 200 752 divulgue un diviseur programmable selon le préambule de la revendication 1.

Un objet de la présente invention est de prévoir une structure, de diviseur programmable rapide, qui puisse être transposée d'une technologie à une autre sans effort de développement.

Cet objet est atteint grâce à un diviseur programmable comprenant plusieurs bascules cadencées par un signal à une fréquence à diviser et disposées de manière à pouvoir être connectées en boucle en un nombre déterminé en fonction d'un taux de division souhaité, caractérisé en ce que la plus petite boucle possible comprend au moins deux bascules successives initialisées à un premier état, suivies immédiatement d'au moins deux bascules successives initialisées à l'état opposé.

Selon un mode de réalisation de la présente invention, la sortie de chaque bascule n'appartenant pas à la plus petite boucle possible est fournie à une première entrée d'un multiplexeur dont une deuxième entrée reçoit la sortie de la dernière bascule de la plus petite boucle possible et dont la sortie est fournie à l'entrée de la bascule suivante, ce multiplexeur étant commandé par un signal indiquant le taux de division souhaité.

Selon un mode de réalisation de la présente invention, toutes les bascules n'appartenant pas à la plus petite boucle possible sont initialisées à un même état.

Selon un mode de réalisation de la présente invention, les bascules sont initialisées par un signal non-synchronisé sur la fréquence à diviser.

Ces objets, caractéristiques, avantages ainsi que d'autres de la présente invention seront exposés en détail dans la description suivante de modes de réalisation particuliers faite à titre non-limitatif à l'aide des figures jointes, parmi lesquelles :
la figure 1, précédemment décrite, représente un diviseur programmable classique ;
la figure 2A représente un mode de réalisation de diviseur programmable à la base de la présente invention ;
la figure 2B représente un chronogramme illustrant le fonctionnement et un inconvénient du diviseur de la figure 2A ; et
la figure 3 représente un mode de réalisation de diviseur programmable selon la présente invention.

Dans la figure 2A, plusieurs bascules sont connectées selon une boucle de taille variable, le nombre total de bascules étant égal au taux de division maximal à obtenir. Les bascules sont de type D, c'est-à-dire que chacune d'elles stocke l'état présent à son entrée à la survenue d'un front actif d'un signal de validation. Le diviseur de la figure 2A comprend six bascules D 10 à 15 toutes validées à la fréquence Fin à diviser. Les trois premières bascules 10 à 12 sont connectées directement en cascade, c'est-à-dire que la sortie Q de chacune de ces bascules est connectée à l'entrée D de la bascule suivante. La sortie Fout du diviseur est prelévée sur la sortie Q de la deuxième bascule 11. L'entrée D de chacune des bascules 13 à 15 et 10 est précédée d'un multiplexeur 17 qui reçoit sur une première entrée la sortie Q de la bascule précédente et, sur une deuxième entrée, la sortie Fout du diviseur. En outre, toutes les bascules, sauf l'une, par exemple 10, des bascules 10 et 11, sont remises à zéro par un signal d'initialisation INIT, la bascule 10 étant mise à 1 par ce signal.

Le signal INIT est activé une seule fois, par exemple à la mise sous tension du circuit. En conséquence, seule la bascule 10 est à 1. Lorsque l'on applique le signal à diviser Fin, ce 1 se met à circuler au rythme du signal Fin dans les bascules d'une boucle sélectionnée grâce aux multiplexeurs 17. En l'absence de commande de l'un des multiplexeurs 17, c'est-à-dire lorsque tous les signaux de commande de ces multiplexeurs sont à 0, la boucle sélectionnée comporte toutes les bascules 10 à 15. Pour sélectionner une boucle plus petite, un seul des signaux de commande des multiplexeurs 17 est mis à 1. Par exemple, si l'on met à 1 le signal de commande du multiplexeur 17 précédant la bascule 15, la boucle comporte les bascules 10, 11 et 15 ; le taux de division alors sélectionné est de 3. En effet, le "1" qui se trouvait dans la bascule 10 initialement atteint alors la bascule 11, et est présenté à la sortie Fout du diviseur, chaque trois cycles du signal à diviser Fin.

Lors du passage d'une boucle à une boucle plus petite, il est possible que le "1" circulant ne se trouve pas dans la petite boucle. Ceci doit être évité, car le "1" circulant est alors perdu. Pour cela, par exemple, on peut synchroniser la sélection d'une nouvelle boucle sur les fronts montants du signal Fout qui indiquent la présence du "1" circulant dans la plus petite boucle possible, constituée des bascules 10 et 11.

Le diviseur de la figure 2A a l'avantage d'être synchrone, puisque toutes les bascules 10 à 15 sont cadencées par le même signal Fin. Ceci permet de transposer ce diviseur d'une technologie à une autre sans se soucier des dimensions des transistors. Toutefois, ce diviseur présente un inconvénient lorsqu'il doit être utilisé à fréquence élevée, cet inconvénient étant illustré à l'aide de la figure 2B.

La figure 2B représente un exemple d'allure des signaux Fin, INIT et des sorties Q10 et Q11 des bascules 10 et 11. Initialement, le signal INIT est à 1, ce qui a pour conséquence de forcer toutes les bascules, sauf la bascule 10, à 0. Le signal INIT passe à 0 un intervalle de temps t avant un front montant du signal Fin, ce qui permet au diviseur de démarrer. Au prochain front montant du signal Fin, la bascule 10 prend l'état 0 de la bascule précédente (15 ou 11) et la bascule 11 prend l'état 1 de la bascule 10. Comme cela est représenté, le signal Q10 passe de 1 à 0 et le signal Qll passe de 0 à 1.

Pour que la bascule 11 puisse prendre l'état 1 de la bascule 10, il est nécessaire que l'intervalle t séparant le front descendant du signal INIT du front montant du signal Fin, soit supérieur au temps de préparation de la bascule. Si cette condition n'est pas respectée, comme cela est représenté en pointillés, la bascule 11 reste à 0 au lieu de prendre l'état 1, ce qui provoque la perte du "1" circulant. Si une synchronisation du front descendant du signal INIT sur le signal Fin s'avère efficace à basse fréquence, il est difficile, à la fréquence limite, de maîtriser la position du front descendant du signal INIT sans de nouveau considérer les dimensions des transistors. En effet, le décalage séparant le front descendant du signal INIT d'un front du signal Fin dépend d'un tel dimensionnement.

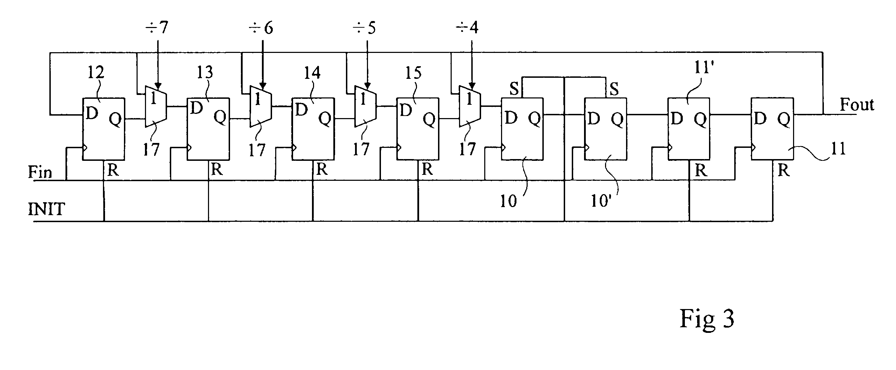

La figure 3 représente un diviseur selon l'invention, réalisé sur la base du diviseur de la figure 2A, mais évitant la possible perte d'un "1" circulant. Ici, comme à la figure 2A, plusieurs bascules 10 à 15 sont connectées selon une boucle de taille variable grâce à des multiplexeurs 17. En outre, le circuit comprend deux bascules supplémentaires 10' et 11' formant avec les bascules 10 et 11 la plus petite boucle possible. Les bascules 10' et 11' sont disposées successivement entre les bascules 10 et 11. La bascule 10', comme la bascule 10, est mise à 1 par le signal INIT tandis que la bascule 11', comme la bascule 11, est mise à 0 par ce signal INIT. Il est ici inutile de synchroniser le signal INIT sur le signal Fin. Le fonctionnement de ce diviseur est similaire à celui de la figure 2A, sauf que le taux de division minimal est de 4, puisque la plus petite boucle possible est constituée des quatre bascules 10, 10', 11 et 11'.

Après une initialisation par le signal INIT, ce sont les bascules 10 et 11' qui peuvent se trouver dans la situation conflictuelle décrite en relation avec la figure 2B. C'est-à-dire que la bascule 10 reste à 1 au lieu de prendre la valeur 0 de la bascule précédente (15 ou 11), ou que la bascule 11' reste à 0 au lieu de prendre l'état 1 de la bascule 10'. Il se présente alors quatre cas possibles :
1) toutes les bascules fonctionnent correctement, les bascules 10, 10', 11' et 11 prennent respectivement les états 0, 1, 1, et 0 au front montant du signal Fin.
2) Seule la bascule 10 ne fonctionne pas correctement. Les bascules 10, 10', 11' et 11 prennent alors respectivement les états 1, 1, 1 et 0 au front montant du signal Fin.
3) Seule la bascule 11' ne fonctionne pas correctement. Alors, les bascules 10, 10', 11' et 11 prennent respectivement les états 0, 1, 0 et 0 au front montant du signal Fin.
4) Les bascules 10 et 11' fonctionnent toutes les deux incorrectement. Alors, les bascules 10, 10', 11' et 11 prennent respectivement les états 1, 1, 0 et 0 au front montant du signal Fin.

Dans tous les cas, on trouve d'un à trois "1" consécutifs dans les bascules 10, 10', 11' et 11, qui vont circuler en boucle au rythme de la fréquence du signal Fin. Il en résulte que le rapport cyclique du signal Fout varie en fonction du nombre de "1" mis en circulation, mais sa fréquence reste la même, égale à celle du signal Fin divisée par le nombre de bascules dans la boucle sélectionnée. Ce comportement convient à la plupart des circuits qui exploitent la sortie du diviseur, car ils sont sensibles seulement aux fronts montants ou descendants de la sortie du diviseur.

Bien entendu, un fonctionnement correct similaire pourra être obtenu en augmentant, dans la plus petite boucle possible, le nombre de bascules initialement mises à 1 (10, 10'), ou le nombre de bascules initialement mises à 0 (11, 11').

Le taux de division minimal du diviseur de la figure 3 est de 4. Ceci n'est en fait pas un inconvénient par rapport au circuit classique de la figure 1. En effet, à fréquence élevée, dans le circuit classique, les opérations de comparer le contenu du compteur 1 au nombre N et puis de remettre le compteur 1 à zéro sont relativement longues. Si on est à la limite de la fréquence de fonctionnement, ce temps atteint généralement trois cycles. Comme le compteur 1 doit au moins compter jusqu'à 1 pour que le diviseur puisse fonctionner, il s'avère donc que le taux de division minimal est également de 4.

De nombreuses variantes et modifications de la présente invention apparaîtront à l'homme du métier. Par exemple, au lieu de mettre toutes les bascules à 0 sauf au moins 2, on peut mettre à 1 toutes les bascules sauf au moins 2.

## Revendications

1. Diviseur programmable comprenant plusieurs bascules (10-15) cadencées par un signal à une fréquence à diviser (Fin) et disposées de manière à pouvoir être connectées en boucle en un nombre déterminé en fonction d'un taux de division souhaité (N), caractérisé en ce que la plus petite boucle possible comprend au moins deux bascules successives (10, 10') initialisées à un premier état (1), suivies immédiatement d'au moins deux bascules successives (11', 11) initialisées à l'état opposé (0).

2. Diviseur programmable selon la revendication 1, caractérisé en ce que la sortie de chaque bascule (12-15) n'appartenant pas à la plus petite boucle possible est fournie à une première entrée d'un multiplexeur (17) dont une deuxième entrée reçoit la sortie de la dernière bascule (11) de la plus petite boucle possible et dont la sortie est fournie à l'entrée de la bascule suivante, ce multiplexeur étant commandé par un signal indiquant le taux de division souhaité.

3. Diviseur programmable selon la revendication 1, caractérisé en ce que toutes les bascules (12-15) n'appartenant pas à la plus petite boucle possible sont initialisées à un même état.

4. Diviseur programmable selon l'une quelconque des revendications 1 à 3, caractérisé en ce que les bascules (10-15) sont initialisées par un signal (INIT) non synchronisé sur la fréquence à diviser.

## Patentansprüche

1. Programmierbarer Teiler mit mehreren Kippschaltungen (10 bis 15), die durch ein Signal mit einer zu teilenden Frequenz (Fin) taktgesteuert werden und derart angeordnet sind, dass sie in einer Schleife in bestimmter Anzahl als Funktion einer gewünschten Teilungsrate (N) zusammengeschaltet werden können, dadurch gekennzeichnet, dass die kleinst mögliche Schleife zumindest zwei aufeinanderfolgende Kippschaltungen (10, 10') enthält, die bei einem ersten Zustand (1) initialisiert werden, gefolgt unmittelbar von mindestens zwei aufeinanderfolgenden Kippschaltungen (11', 11), die bei dem entgegengesetzten Zustand (0) initialisiert werden.

2. Programmierbarer Teiler nach Anspruch 1, dadurch gekennzeichnet, dass der Ausgang jeder Kippschaltung (12 bis 15), die nicht zu der kleinst möglichen Schleife gehört, mit einem ersten Eingang eines Multiplexers (17) verbunden ist, dessen zweiter Eingang das Ausgangssignal der ersten Kippschaltung (11) der kleinst möglichen Schleife empfängt und dessen Ausgang mit dem Eingang der folgenden Kippschaltung verbunden ist, wobei dieser Multiplexer durch ein Signal gesteuert wird, das die gewünschte Teilungsrate angibt.

3. Programmierbarer Teiler nach Anspruch 1, dadurch gekennzeichnet, dass alle Kippschaltungen (12 bis 15), die nicht zu der kleinst möglichen Schleife gehören, bei einem gleichen Zustand initialisiert werden.

4. Programmierbarer Teiler nach einem der Ansprüche 1 bis 3, dadurch gekennzeichnet, dass die Kippschaltungen (10 bis 15) durch ein Signal (INIT) initialisiert werden, das nicht auf die zu teilende Frequenz synchronisiert ist.

## Claims

1. A programmable divider including several flip-flops (10-15) clocked by a signal at a frequency to divide (Fin) and arranged so as to allow the connection in a ring of a predetermined number of them, selected according to a desired division ratio (N), characterized in that the smallest selectable ring includes at least two successive flip-flops (10, 10') initialized at a first state (1), immediately followed by at least two successive flip-flops (11', 11) initialized at the opposite state (0).

2. A programmable divider according to claim 1, characterized in that an output of each flip-flop (12-15) which does not belong to the smallest selectable ring is provided to a first input of a multiplexer (17) having a second input which receives the output of the last flip-flop (11) of the smallest selectable ring, and an output which is provided to the input of the next flip-flop, this multiplexer being controlled by a signal indicating the desired division ratio.

3. A programmable divider according to claim 1, characterized in that all the flip-flops (12-15) which do not belong to the smallest selectable ring are initialized at a same state.

4. A programmable divider according to any of claims 1 to 3, characterized in that the flip-flops (10-15) are initialized by a signal (INIT) which is not synchronized on the frequency to divide.
